Europäisches Patentamt

**European Patent Office**

Office européen des brevets

(11) Publication number: **0 150 076 B1**

# (12) EUROPEAN PATENT SPECIFICATION

(45) Date of publication of patent specification: **28.08.91**   (51) Int. Cl.⁵: **H03M 9/00**

(21) Application number: **85200009.0**

(22) Date of filing: **09.01.85**

(54) **Parallel-series converter.**

(30) Priority: **11.01.84 NL 8400090**

(43) Date of publication of application:
**31.07.85 Bulletin 85/31**

(45) Publication of the grant of the patent:
**28.08.91 Bulletin 91/35**

(84) Designated Contracting States:
**BE DE FR GB IT SE**

(56) References cited:
**EP-A- 0 012 306**
**US-A- 2 444 438**

**IEEE TRANSACTIONS ON NUCLEAR SCIENCE, vol. NS-11, no. 2, April 1964, pages 10-15, New York, US; P. STUBER: "Linear parallel to serial conversion"**

**INSTRUMENTS AND EXPERIMENTAL TECHNIQUES, no. 2, March/April 1968, pages 341-344, New York, US; V.G. VOVCHENKO et al.: "Circuit for registering pulses from a photomultiplier"**

(73) Proprietor: **N.V. Philips' Gloeilampenfabrieken**
**Groenewoudseweg 1**
**NL-5621 BA Eindhoven(NL)**

(72) Inventor: **Wagenmakers, Johannes**
**c/o INT. OCTROOIBUREAU B.V. Prof. Holstlaan 6**
**NL-5656 AA Eindhoven(NL)**

(74) Representative: **Bakker, Hendrik et al**
**INTERNATIONAAL OCTROOIBUREAU B.V.**
**Prof. Holstlaan 6**
**NL-5656 AA Eindhoven(NL)**

## Description

The invention relates to a converter for converting parallely presented pulse trains having a plurality of parallel inputs and comprising a combining arrangement having a plurality of inputs equal in number to the plurality of parallel inputs of the converter, and an output, each parallel input being coupled via a transmission line to a respective one of the inputs of the combining arrangement, each transmission line being coupled to a short-circuited transmission line, each of the inputs of the combining arrangement being coupled to the base electrode of a transistor, the collectors of these transistors being coupled to each other and the emitters of these transistors being coupled to each other, the junction of the collectors being coupled to the output of the converter via an impedance and being connectable to a different supply point, the junction of the emitters being connectable to a different supply point via a further a further impedance.

Such a converter is described in "Instruments and Experimental Techniques", No. 2, March/april 1968, pages 341-344. This known converter is a parallel-parallel converter fo use in a coincidence-anticoincidence circuit of circuit for registering pulses from a photo-multiplier. In this known converter the short-circuited transmission lines are used to influence the pulse duration and shape.

In digital transmission systems it often happens that the wish is felt for converting n parallel spatially separated bit streams of p bits/seconds each, into one serial bit streams, without loss of information. In this serial bit stream the individual n bit streams are now separated in time. This procedure is known as the parallel-series conversion, the serial digital signal having a frequency equal to $n \times p$ bits/second.

In digital transmission systems it is normal practice to effect such parallel-series conversion only with the aid of active digital circuits. These active circuits are integrated with further portions of the transmission system on, for example, a semiconductor body. The use of integrated active digital circuits increase the total required dissipation of the semiconductor body. This may cause design problems in connection with the maximum permissible dissipation of the semiconductor body.

The invention therefore has for its object to implement the known converter as a parallel-series converter, without the necessity to apply additional active digital circuits,

To this effect the invention is characterized in that the converter is a parallel-series converter wherein the time delays of the individual transmission lines have respective different magnitudes according to an arithmetical progression; that the short-circuited transmission lines have a length $\lambda/2$, where $\lambda$ is the wavelength of the desired output frequency of the parallel-series converter; that each original pulse, as applied to an input of the parallel-series converter, is overlapped by the inverted pulse coming form the short-circuited transmission line such, that the original pulse during the overlap time is wholly, or substantially wholly, eliminated, and in that the combining circuit comprises a blocking transistor whose collector is coupled to the output of the parallel-series converter, whose emitter is coupled to the junction of the emitters of the aforesaid transistors, and whose base is connectable to a point of reference voltage, such that pulses with a fixed polarity are blocked and pulses with the opposite polarity appear at the output of the parallel-series converter.

By using in the converter according to the invention the short-circuited transmission line, an inverted pulse is created that overlaps the original pulse substantially. Out of the original pulse two pulses of shorter duration are created with opposite polarities. These pulses for each input are delayed by means of a further transmission line with different time delays and combined in the combining circuit. For an error-free operation of the converter pulses with one fixed polarity are blocked in the blocking circuit.

So, n parallel, spatially separated bit streams of p bits/econd are converted into one serial bit stream of $n \times p$ bits/second without loss of information.

The transmission lines are easily integratable and do not dissipate, which is of great advantage.

It is observed that from IEEE Transactions on Nuclear Science, Vol. NS-11, No. 2, April 1964, pages 10 to 15, a parallel-series converter is known that converts a fixed number of pulses at the output. With the bitrate at the input and the bitrate at the output being the same, a minimun time of the number of parallel pulses multiplied by the duration of a single pulse must pass before another number of parallel pulses can be converted.

Further, from US-A 2,444,438 a pulse generator is known that cuts one pulse that is present at the input into a smaller one at the output by using a reflection network and clipping a selected portion of the resulting pulse energy.

Both the known converter and the known generator have the same bitrate at the input and at the output.

In a parallel-series converter according to the invention, use is made predominantly of passive elements to effect the parallel-series conversion. As a result, the additional dissipation due to the parallel-series converter and added to the total dissipation is drastically reduced.

The invention will now be described in greater detail by way of example with reference to the accompanying drawings, in which

Fig. 1 shows an embodiment of a parallel-series converter according to the invention; and

Fig. 2 shows a time diagram to explain the operation of the parallel-series converter.

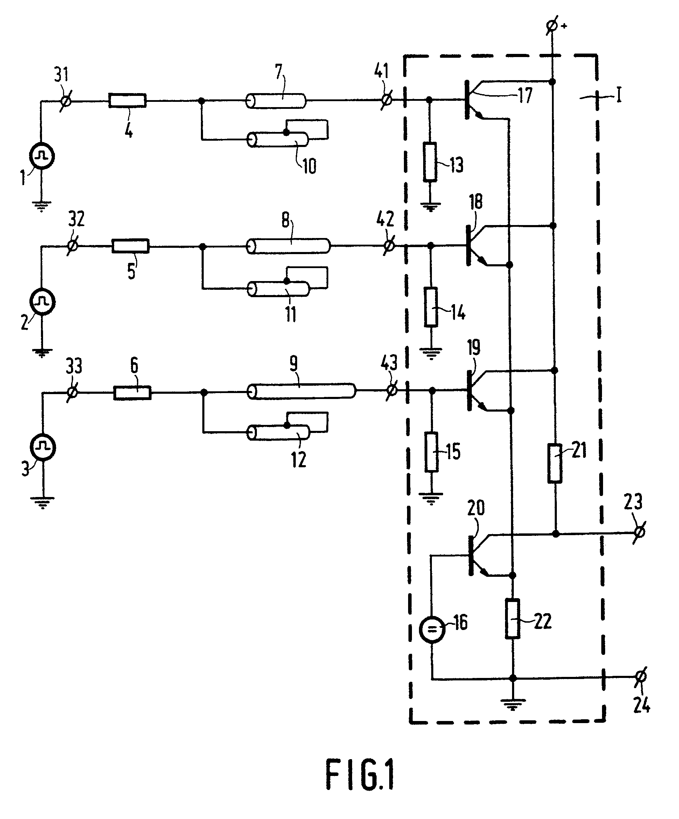

In the parallel-series converter shown in Fig. 1, the parallel inputs are constituted by the terminals 31, 32 and 33 and the information is applied to these terminals by sources 1, 2 and 3. The input 31 is connected to a first input 41 of a combining arrangement I via the series arrangement of a terminating impedance 4 and a transmission line 7. The input 32 is connected to a second input 42 of the combining arrangement I via the series arrangement of a terminating impedance 5 and a transmission line 8. The input 33 is connected to a third input 43 of the combining arrangement I via the series arrangement of a terminating impedance 6 and a transmission line 9. The input 41 is connected to a terminating impedance 13 and also to the base electrode of a transistor 17. The input 42 is connected to a terminating impedance 14 and also to the base electrode of a transistor 18. The input 43 is connected to a terminating impedance 15 and also to the base electrode of a transistor 19. The collectors of the transistors 17, 18 and 19 are connected to the positive pole (+) of a supply voltage and also via a resistor 21 to an output 23 of the parallel-series converter. The collector of a transistor 20 is connected to the output 23 of the parallel-series converter. The emitters of the transistors 17, 18, 29 and 20 are connected in common to a point 24 of constant potential via a resistor 22. The base electrode of the transistor 20 is connected to a source of reference voltage 16. The junction point of the terminating impedance 4 and the transmission line 7 is connected to a short-circuited transmission line 10. The junction of the terminating impedance 5 and the transmission line 8 is connected to a short-circuited transmission line 11. The junction of the terminating impedance 6 and the transmission line 9 is connected to a short-circuited transmission line 12.

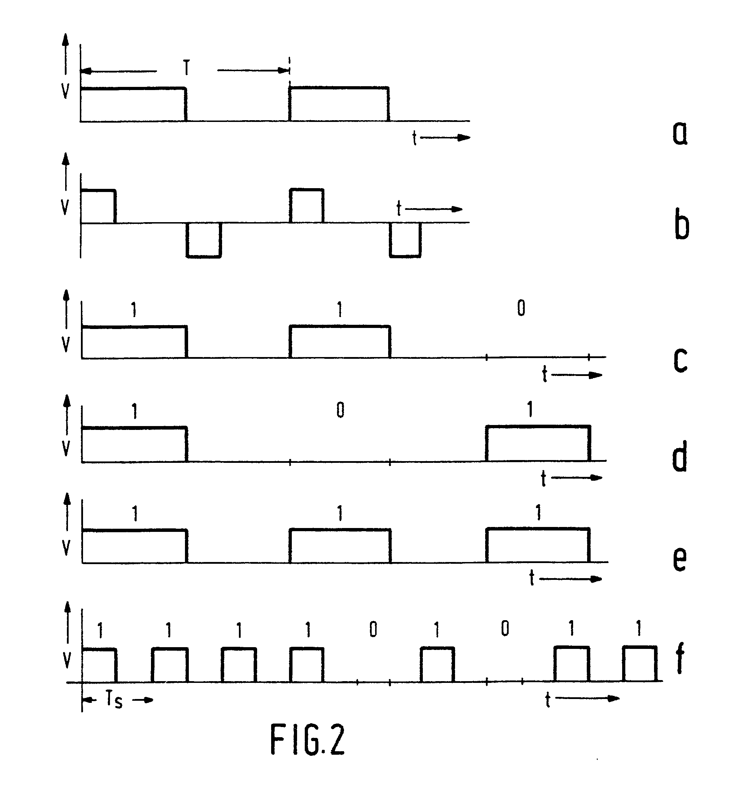

A digital signal, which is of the shape shown in Fig. 2a, is applied to the inputs of the parallel-series converter. The widths of the pulses applied to the inputs are limited, such as described, for example, in United States Patent 3,515,995. This is necessary as otherwise loss of information would occur in the parallel-series converter. In addition, negative reflection pulses are produced at the input of the short-circuited transmission line, as shown in Fig. 2b. These reflection pulses are unwanted and are suppressed in the combining arrangement I with the aid of the transistor 20 and the reference voltage 16 source. Mutatis mutandis it is alternatively possible to utilize the negative pulse and to eliminate the positive pulse. A further method of suppressing the unwanted reflection pulses is, for example, to provide a diode between the short-circuited transmission line 10 and the transmission line 7. This diode is arranged such that only the positive pulses are allowed to pass to the transmission line 7. Fig. 2c shows by way of example a voltage variation of the pulses produced by the source 1. Fig. 2d shows by way of example a voltage variation of pulses produced by the source 2 and Fig. 2e shows the voltage variation of the pulses produced by source 3.

In response thereto, the three parallel bit streams (1, 1, 1), (1, 0, 1) and (0, 1, 1) appear in this succession at the inputs 31, 32 and 33. Due to the action of the respective short-circuited transmission lines 10, 11 and 12, the pulse widths of the pulses from these parallel bit streams are limited as is shown in Fig. 2b. The three parallel bit streams of three bits each are thereafter applied to the inputs 41, 42 and 43 of the combining arrangement I. The transistors 17, 18, 19 and 20 together form a multiple OR-gate. With the aid of the transistors 17, 18 and 19 the three parallel bit streams are arranged time-sequentially as is shown in Fig. 2f. The emitter of the transistor 20 is adjusted to such a potential with the aid of the reference voltage source 16 that the above-mentioned negative reflection pulses as shown in Fig. 2b are blocked and do not occur at the output 23 of the parallel-series converter. The repetition rate $T_s$ of the serial pulses at the output 23 is equal to 1/3 T, where T is the repetition rate of the pulses at the inputs 31, 32 and 33 of the parallel-series converter. The time delays $\tau$ of the transmission lines 7, 8 and 9 are adjusted such that the pulses of limited widths which are obtained, appear one after the other at the respective inputs 41, 42 and 43. A possible choice of these time delays is, for example, $\tau$ (7) = 0, $\tau$ (8) = $T_s$ and $\tau$ (9) = 2 $T_s$, see Fig. 2f. These transmission lines can be realized, depending on the frequency range in which the digital transmission system is operated, with the aid of printed conductors, cables, microstrips etc.

## Claims

1. A converter for converting pulse trains presented in parallel having a plurality of parallel inputs (31, 32, 33) and comprising a combining arrangement (I) having a plurality of inputs (41, 42, 43) equal in number to the plurality of parallel inputs (31, 32, 33) of the converter, and an output, each parallel input (31, 32, 33) being coupled via a transmission line (7, 8, 9) to a respective one of the inputs (41, 42, 43) of the combining arrangement (I), each transmission line (7, 8, 9) being coupled to a short-circuited transmission line (10, 11, 12), each of the inputs (41, 42, 43) of the combining arrangement (I) being coupled to the base electrode of a transistor (17, 18, 19), the collectors of these transistors (17, 18, 19) being coupled to each other and the emitters of these transistors being coupled to each other, the junction of the collectors being coupled to the output (23) of the converter via an impedance (21) and being connectable to a supply point, the junction of the emitters being connectable to a different supply point via a further impedance (22), characterized in that the converter is a parallel-series converter wherein the time delays of the individual transmission lines (7, 8, 9) have respective different magnitudes according to an arithmetical progression; that the short-circuited transmission lines (10, 11, 12) have a length λ/2, where λ is the wavelength of the desired output frequency of the parallel-series converter; that each original pulse, as applied to an input (31, 32, 33) of the parallel-series converter, is overlapped by the inverted pulse coming from the short-circuited transmission line (10, 11, 12) such, that the original pulse during the overlap time is wholly, or substantially wholly, eliminated, and in that the combining circuit (I) comprises a blocking transistor (20) whose collector is coupled to the output (23) of the parallel-series converter, whose emitter is coupled to the junction of the emitters of the aforesaid transistors (17, 18, 19), and whose base is connectable to a point of reference voltage, such that pulses with a fixed polarity are blocked and pulses with the opposite polarity appear at the output of the parallel-series converter.

## Revendications

1. Convertisseur pour la conversion de trains d'impulsions présentés en parallèle, comportant une pluralité d'entrées parallèles (31, 32, 33) et comprenant un dispositif combineur (I) présentant une pluralité d'entrées (41, 42, 43) égale en nombre à la pluralité d'entrées parallèles (31, 32, 33) du convertisseur, et une sortie, chaque entrée parallèle (31, 32, 33) étant couplée, par l'intermédiaire d'une ligne de transmission (7, 8, 9), à une entrée respective parmi les entrées (41, 42, 43) du dispositif combineur (I), chaque ligne de transmission (7, 8, 9) étant couplée à une ligne de transmission en court-circuit (10, 11, 12), chacune des entrées (41, 42, 43) du dispositif combineur (I) étant couplée à la base d'un transistor (17, 18, 19), les collecteurs de ces transistors étant couplés l'un à l'autre et leurs émetteurs étant couplés l'un à l'autre, la jonction des collecteurs étant couplée à la sortie (23) du convertisseur par l'intermédiaire d'une impédance (21) et pouvant être connectée à un point d'alimentation, la jonction des émetteurs pouvant être connectée à un point d'alimentation différent par l'intermédiaire d'une autre impédance (22), caractérisé en ce que le convertisseur est un convertisseur parallèle-série, dans lequel les retards des lignes de transmission individuelles (7, 8, 9) présentent des grandeurs différentes respectives selon une progression arithmétique; que les lignes de transmission en court-circuit (10, 11, 12) ont une longueur λ/2, où λ est la longueur d'onde de la fréquence de sortie souhaitée du convertisseur parallèle-série; que chaque impulsion d'origine telle qu'elle est appliquée à une entrée (31, 32, 33) du convertisseur parallèle-série est chevauchée par l'impulsion inversée provenant de la ligne de transmission en court-circuit (10, 11, 12), de sorte que l'impulsion d'origine, pendant le temps de chevauchement, est entièrement ou en substance entièrement éliminée, et en ce que le circuit combineur (I) comprend un transistor de blocage (20), dont le collecteur est couplé à la sortie (23) du convertisseur parallèle-série, dont l'émetteur est couplé à la jonction des émetteurs des transistors (17, 18, 19) précités et dont la base peut être connectée à un point de tension de référence, de sorte que des impulsions présentant une polarité fixe sont bloquées et que des impulsions présentant la polarité opposée apparaissent à la sortie du convertisseur parallèle-série.

## Patentansprüche

1. Wandler zum Umwandeln parallel zugeführter Impulsfolgen mit einer Anzahl paralleler Eingänge (31, 32, 33) und mit einer Kombinieranordnung (I) mit einer Anzahl Eingänge (41, 42, 43) entsprechend der Anzahl Eingänge (31, 32, 33) des Wandlers, und mit einem Ausgang, wobei jeder parallele Eingang (31, 32, 33) über eine Übetragungsleitung (7, 8, 9) mit einem jeweiligen Eingang (41, 42 bzw. 43) der Kombinieranordnung (I) gekoppelt ist, wobei jede Übertragungsleitung (7, 8, 9) mit einer kurzgeschlossenen Übertragungsleitung (10, 11, 12) gekoppelt ist, wobei jeder der Eingänge (41, 42, 43) der Kombinieranordnung (I) mit der Basiselektrode eines Transistors (17, 18, 19) verbunden ist, wobei die Kollektorelektroden dieser Transistoren (17, 18, 19) sowie die Emitterelektroden derselben miteinander verbunden sind, wobei der Knotenpunkt der Kollektorelektroden über eine Impedanz (21) mit dem Ausgang (23) des Wandlers gekoppelt und mit einem Speisepunkt verbindbar ist, wobei der Knotenpunkt der Emitterelektroden über eine weitere Impedanz (22) mit einem anderen Speisepunkt verbindbar ist, dadurch gekennzeichnet, daß der Wandler ein Parallel-Reihe-Wandler ist, bei dem die Zeitverzögerungen der jeweiligen Übertragungsleitungen (7, 8, 9) je einen anderen Wert haben, und zwar entsprechend einer arithmetischen Reihe; daß die kurzgeschlossenen Übertragungsleitungen (10, 11, 12) eine Länge aufweisen von λ/2, wobei λ die Wellenlänge der gewünschten Ausgangsfrequenz des Parallel-Reihe-Wandlers ist; daß jeder ursprüngliche Impuls, wie dieser einem Eingang (31, 32, 33) des Parallel-Reihe-Wandlers zugeführt wird, durch den von der kurzgeschlossenen Übertragungsleitung (10, 11, 12) herrührenden invertierten Impuls derart überlappt wird, daß der ursprüngliche Impuls während der Überlappungszeit völlig oder nahezu völlig unterdrückt wird, und daß die Kombinieranordnung (I) einen Sperrtransistor (20) aufweist, dessen Kollektor mit dem Ausgang (23) des Parallel-Reihe-Wandlers gekoppelt ist, dessen Emitter mit dem Knotenpunkt der Emitterelektroden der genannten Transistoren (17, 18, 19) gekoppelt ist, und dessen Basis mit einem Bezugsspannungspunkt derart verbindbar ist, daß Impulse mit einer festen Polarität gesperrt werden und Impulse mit der entgegengesetzten Polarität an dem Ausgang des Parallel-Reihe-Wandlers erscheinen.

FIG.1

FIG.2